# EUROPEAN PATENT SPECIFICATION

(11) **EP 4 058 841 B1**
(45) Date of publication and mention of the grant of the patent: **07.10.2026**
(21) Application number: 20807013.6
(22) Date of filing: 12.11.2020
(51) Int. Cl.: G02F 1/025

(54) **OPTOELECTRONIC DEVICE AND METHOD OF MANUFACTURE THEREOF**
OPTOELEKTRONISCHE VORRICHTUNG UND ZUGEHÖRIGES HERSTELLUNGSVERFAHREN
DISPOSITIF OPTOÉLECTRONIQUE ET PROCÉDÉ DE FABRICATION ASSOCIÉ

(30) Priority: 15.11.2019 GB 201916700; 08.09.2020 US 202063075645 P; 10.09.2020 US 202063076719 P
(43) Date of publication of application: 21.09.2022
(73) Proprietor: Chamartin Laboratories LLC, Wilmington, DE 19801 (US)
(72) Inventor: YU, Guomin, Pasadena, California 91101 (US); ZILKIE, Aaron John, Pasadena, California 91101 (US)
(74) Representative: Rooney, John-Paul
(86) International application number: PCT/EP2020/081949
(87) International publication number: WO 2021/094473

(56) References cited:
- ZHANG JING ET AL: "III-V-on-Si photonic integrated circuits realized using micro-transfer-printing", APL PHOTONICS, AMERICAN INSTITUTE OF PHYSICS, 2 HUNTINGTON QUADRANGLE, MELVILLE, NY 11747, vol. 4, no. 11, 4 November 2019 (2019-11-04), XP012241950, DOI: 10.1063/1.5120004
- ROELKENS G ET AL: "Transfer Printing for Silicon Photonics Transceivers and Interposers", 2018 IEEE OPTICAL INTERCONNECTS CONFERENCE (OI), IEEE, 4 June 2018 (2018-06-04), pages 13 - 14, XP033379194, DOI: 10.1109/OIC.2018.8422030
- YUKI HASHIMOTO ET AL: "Fabrication of an Anti-Reflective and Super-Hydrophobic Structure by Vacuum Ultraviolet Light-Assisted Bonding and Nanoscale Pattern Transfer", MICROMACHINES, vol. 9, no. 4, 1 April 2018 (2018-04-01), CH, pages 186, XP055768453, ISSN: 2072-666X, DOI: 10.3390/mi9040186

## Description

### Field of the Invention

The present invention relates to an optoelectronic device and method of making the same.

### Background

Hybrid integration of III-V semiconductor based electro-optical devices, (e.g. modulators) with silicon-on-insulator (SOI) platforms by chip bonding confers the advantage of combining the best parts of both material systems.

However, conventional chip bonding processes typically use flip-chip bonding, in which the III-V semiconductor based device is upside down and bonded into a cavity on the SOI platform. Devices fabricated using these methods typically suffer from high optical coupling losses between a waveguide in the III-V semiconductor based device and a waveguide in the SOI. Further the manufacturing process has a low yield, and relatively low reliability because of difficulties in accurately controlling the alignment of the respective waveguides.

Micro-transfer printing (MTP) is therefore being looked into, as an alternative way to integrate III-V semiconductor based devices with SOI wafers. In these methods, the III-V semiconductor based device can be printed into a cavity on the SOI in the same orientation it was manufactured, and the alignment between the III-V semiconductor based waveguide and the SOI waveguide is pre-determined in the vertical direction (Z-direction). The requirements for alignment are therefore reduced from three dimensions to two, which can be more easily facilitated.

However, an issue with MTP arises from the gap that exists between the III-V semiconductor based waveguide and the SOI waveguide facets. Although the gap width can typically be well controlled (e.g. within the range 0.5 µm to 1.5 µm) it can cause the following issues: (i) a high optical coupling loss between the III-V semiconductor based waveguide and the SOI waveguide; and (ii) it leaves a gap in which particles, debris, or dirt may infiltrate, which can block the optical path, this reduces the device's long term reliability.

Therefore there is a need for a method of manufacturing an optoelectronic device, and the resultant optoelectronic device, which overcomes the shortcomings identified above. ZHANG JING ET AL: "III-V-on-Si photonic integrated circuits realized using micro-transfer printing", APL PHOTONICS, AMERICAN INSTITUTE OF PHYSICS, 2 HUNTINGDON QUADRANGLE, MELVILLE, NY 11747, vol. 4, no. 11, 4 November 2019 discusses micro-transfer printing.

### Summary

Accordingly, embodiments of a first aspect of the invention provide a method of manufacturing an optoelectronic device, the manufactured device including a photonic component coupled to a waveguide, the method comprising:
providing a device coupon, the device coupon including the photonic component;
providing a platform, the platform comprising a cavity within which is a bonding surface for the device coupon;
transfer printing the device coupon onto the cavity, such that a surface of the device coupon directly abuts the bonding surface and at least one channel is present between the device coupon and a sidewall of the cavity; and
filling the at least one channel with a filling material via a spin-coating process, to form a bridge coupling the photonic component to the waveguide.

The method uses simple fabrication processes, and the method is suitable for volume production. Moreover, the resulting devices demonstrate reduced levels of optical loss.

The method may have any one or, to the extent that they are compatible, any combination of the following optional features.

The photonic component may be a III-V semiconductor based photonic component, that is the photonic component may be made of III-V materials. The waveguide may be a silicon waveguide. The platform may be a silicon platform. The waveguide may be a silicon nitride waveguide.

The photonic component may be a II-VI or group IV based photonic component in that it may be made of II-VI or group IV materials. The photonic component may include a bulk semiconductor layer, a quantum well layer, a quantum dot layer, and a quantum dash layer, or any combination thereof, all with or without a Bragg grating. The Bragg grating may be located above or below (in a direction perpendicular to a substrate) the quantum well, quantum dot, or quantum dash layer.

The quantum well layer may comprise regular (e.g. rectangular) quantum wells or triangular quantum wells. The regular quantum wells have a flat energy band in each quantum well conduction band and valence band, and the triangular quantum wells have a V shape energy band in each quantum well conduction band and an inverted V shape in each quantum well valence band.

The photonic component may be any one of: an electro-absorption modulator; a laser; a photodetector; a semiconductor optical amplifier. The device coupon may include two or more photonic components, and may include any combination of the photonic components listed above. For example the device coupon may include a laser and an electro-absorption modulator; a laser, an electro-absorption modulator, and a semiconductor optical amplifier; or a laser, an electro-absorption modulator, a semiconductor optical amplifier, and a photodetector. The photonic component may be configured to function as a gain chip for a laser, as a photodetector, as an electro-absorption modulator, or as a phase modulator.

The waveguide, which is located on the platform, may include a waveguide grating. The waveguide grating may be a silicon waveguide grating, or a silicon nitride waveguide grating. The grating may be a Bragg grating.

The platform may include one or more passive devices, coupled to the waveguide. The passive device may be one of: an arrayed waveguide grating; an Echelle grating; a Mach-Zehnder interferometer; a multimode interferometer; a ring resonator; and a directional coupler.

The combination of the photonic component and waveguide may provide a distributed-feedback (DFB) laser, or distributed Bragg reflector (DBR) laser. When the combination results in a DFB laser, the photonic component may be a gain coupon with a Bragg grating, and be coupled to any of the following types of waveguide:
passive silicon waveguide;
functional silicon waveguide device coupled to a passive silicon waveguide;
a passive silicon nitride (e.g. Si₃N₄) waveguide;
a functional silicon nitride waveguide device coupled to a passive silicon nitride waveguide;
a passive silicon nitride coupled to a silicon waveguide; and
a functional silicon nitride waveguide device coupled to a passive silicon nitride waveguide which is coupled to a passive silicon waveguide.

When the combination results in a DBR laser, the photonic component may be a gain coupon and may be coupled to any of the following:
a silicon waveguide grating coupled to a passive silicon waveguide;
a silicon waveguide grating coupled to a functional silicon waveguide device which is coupled to a passive silicon waveguide;
a silicon nitride waveguide grating coupled to a passive silicon nitride waveguide;
a silicon nitride waveguide grating coupled to a functional silicon nitride waveguide device which is coupled to a passive silicon nitride waveguide;
a silicon nitride waveguide grating coupled to a passive silicon nitride waveguide which is coupled to a passive silicon waveguide;
and a silicon nitride waveguide grating coupled to a functional silicon nitride waveguide device which is coupled to a passive silicon nitride waveguide which is in turn coupled to a passive silicon waveguide.

The photonic component may be an electro-absorption modulator, and be coupled to any of the following:
a functional silicon waveguide device which is coupled to a silicon waveguide;
a passive silicon nitride waveguide;
a passive silicon nitride waveguide coupled to a passive silicon waveguide;
a functional silicon nitride waveguide device coupled to a passive silicon nitride waveguide; and
a functional silicon nitride waveguide device coupled to a passive silicon nitride waveguide which is coupled to a passive silicon waveguide.

The photonic component may be a photodetector, and may be coupled to any of the following:
a passive silicon waveguide;
a functional silicon waveguide device coupled to a passive silicon waveguide;
a passive silicon nitride waveguide;
a functional silicon nitride waveguide device coupled to a passive silicon nitride waveguide;
a passive silicon nitride waveguide coupled to a passive silicon waveguide; and
a functional silicon nitride waveguide device coupled to a passive silicon nitride waveguide which is coupled to a passive silicon waveguide.

The photonic component may be a phase modulator, and may form a part of a silicon or silicon nitride waveguide forming an arm of a Mach-Zehnder interferometer.

A passive waveguide may comprise a straight segment, or a curved segment, or a combination of a straight segment and a curved segment.

By functional waveguide device, it may be meant that the waveguide contains an active device, in some examples the waveguide contains one or more of: a gain medium for a laser; a photodetector; an electro-absorption modulator; or a phase modulator.

The photonic component may include a waveguide. One or more photonic components may be integrated into the waveguide. The waveguide may be a III-V semiconductor based waveguide

The bridge may not be waveguide, in that it may not function so as to confine an optical mode within the bridge structure.

The method may include a step of curing the filling material after it has been spun coated. For example, the filling material may be cured by UV or thermal curing.

The device coupon may include a first and second electrode. As such, the photonic component can be tested and characterised before it is bonded to the silicon platform. Correspondingly, the yield of the method may be higher as malfunctioning or poorly fabricated device coupons are not used (and so silicon platforms are preserved).

A silicon waveguide may be in a device layer of a silicon-on-insulator wafer provided in the platform, and the silicon waveguide may directly abut the cavity.

The silicon waveguide may include a waveguide tapering in height in a direction towards the cavity, from a first height to a second height, the first height being greater than the second height. Accordingly, the height of the silicon waveguide may decrease as it approaches the cavity. The resulting taper may function as a mode converter, between an optical mode within the III-V semiconductor based photonic component and an output waveguide of the resulting optoelectronic device.

The silicon waveguide may include a T-bar end portion, positioned adjacent to the cavity.

The photonic component may include a U-shaped waveguide, and the platform may include two waveguides, each coupled to a respective leg of the U-shaped waveguide. As such, the input and output waveguides of the optoelectronic device may be provided on a same side of the device.

The method may include a step, before filling the channel, of lining one or more sidewalls of the cavity with an anti-reflective liner.

The method may include a step, before transfer printing the device coupon, of providing an anti-reflective coating around one or more lateral side of the device coupon. The anti-reflective coating can serve to protect the lateral sides of the device coupon during the transfer printing process.

The method may include a step, after filling the channel, of covering the channel with a cladding layer. This isolates the filling material from moisture, which makes the resulting device more reliable. The cladding layer is, in some embodiments, silicon dioxide.

The method may include a step, after transfer printing the device coupon into the cavity, of providing electrode contact pads on the silicon platform, and electrically connecting them to the component. The resulting device has a reduction in parasitic capacitance, and so may operate faster.

The method may include a step, before transfer printing the device coupon, of providing an adhesive layer which forms the bonding surface of the cavity.

The method may include a step, after transfer printing the device coupon, of annealing the device coupon and silicon-on-insulator wafer.

The photonic component may include a waveguide including a T-bar end portion which, when printed into the cavity, may be positioned adjacent to the channel. The waveguide may be a III-V semiconductor based waveguide.

The filling material may be a polymer. For example, the filling material may be Benzocyclobutene. In other embodiments the filling material is a sol-gel.

In a second aspect, embodiments of the present invention provide an optoelectronic device, including:
a waveguide, provided in a device layer of a wafer;
a photonic component of a device coupon, located within a cavity of the wafer; and
a bridge, which optically couples the waveguide to the photonic component at a sidewall of the cavity;
wherein the bridge is at least partially formed of a filling material (907) that includes a polymer.

Such an optoelectronic device has been found to have decreased optical loss between the silicon waveguide and the III-V semiconductor based photonic component.

The optoelectronic device may have any one or, to the extent that they are compatible, any combination of the following optional features.

The bridge may not be waveguide, in that it may not function so as to confine an optical mode within the bridge structure.

The bridge may also include one or more anti-reflective coatings. The bridge may include a pair of anti-reflective coatings, located on opposing sides of the polymer. One of the pair of anti-reflective coatings is formed of a layer of silicon nitride located between a pair of silicon dioxide layers.

The bridge may be covered by a passivation layer. This isolates the bridge from moisture, which makes the resulting device more reliable. The passivation layer is, in some embodiments, silicon dioxide.

The polymer may be Benzocyclobutene. The polymer may be sol-gel.

### Brief Description of the Drawings

Embodiments of the invention will now be described by way of example with reference to the accompanying drawings in which:
Figure 1A and 1B show, respectively, a top-down and section view of an optoelectronic device according to an embodiment of the present invention;
Figure 2A and 2B show, respectively, a top-down and section view of a variant optoelectronic device according to an embodiment of the present invention;
Figure 3A - 3E show, respectively, a top-down view and sections view of a III-V waveguide and SOI waveguide interface according to embodiments of the present invention;
Figures 5 show further detail of a bridge and coupling structure;
Figure 6 is a plot of coupling loss (dB) against wavelength (nm) for a simulated bridge and coupling structure;
Figures 7(i) to 7(vi) show various manufacturing stages of a device coupon according to an embodiment of the present invention;
Figures 8(i) to 8(v) show various manufacturing stages of a variant device coupon according to an embodiment of the present invention;
Figures 9(i) to 9(v) show various manufacturing stages of a silicon platform according to an embodiment of the present invention;
Figures 10(i) to 10(viii) show various manufacturing stages of an optoelectronic device according to an embodiment of the present invention;
Figures 11(i) to 11(v) show various variant manufacturing stage of an optoelectronic device according to an embodiment of the present invention;
Figure 12 shows a section view of two optoelectronic devices on a single silicon platform according an embodiment of the present invention;
Figure 13 shows a section view of three optoelectronic devices on a single silicon platform according to an embodiment of the present invention;
Figure 14 shows a section view of a variant optoelectronic device according to an embodiment of the present invention;
Figure 15 shows a section view of a variant optoelectronic device according to an embodiment of the present invention;
Figure 16 shows a section view of a variant optoelectronic device according to an embodiment of the present invention;
Figure 17shows a section view of a variant optoelectronic device according to an embodiment of the present invention;
Figure 18 shows a section view of a variant optoelectronic device according to an embodiment of the present invention; and
Figure 19 shows a section view of a variant optoelectronic device according to an embodiment of the present invention.

### Detailed Description and Further Optional Features

Aspects and embodiments of the present invention will now be discussed with reference to the accompanying figures. Further aspects and embodiments will be apparent to those skilled in the art.

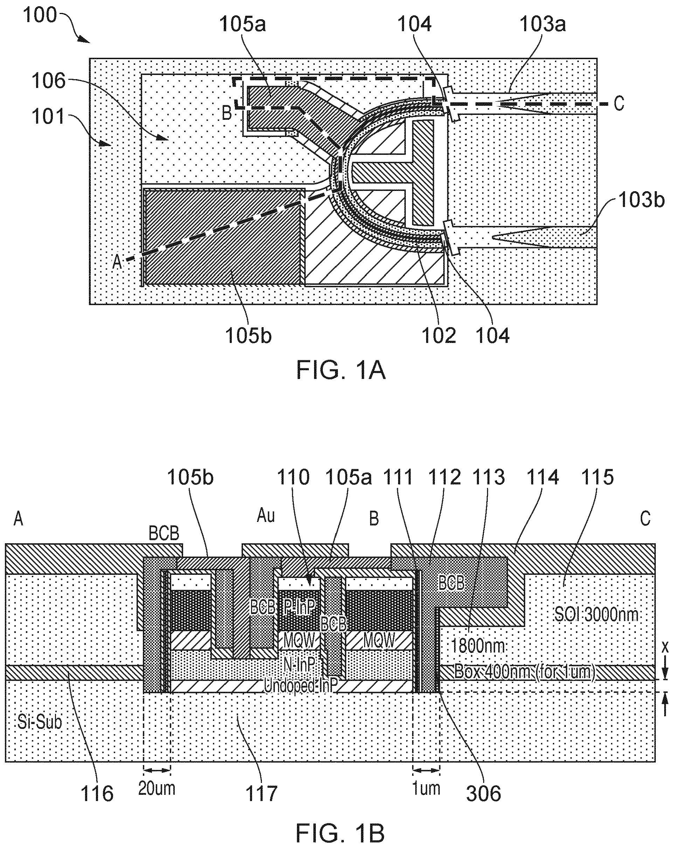

Figure 1A and 1B show, respectively, a top-down and section view of an optoelectronic device according to an embodiment of the present invention. As can be seen in Figure 1A, the optoelectronic device 100 broadly comprises a silicon platform 101, containing silicon waveguides 103a and 103b. The silicon waveguides function as input and output waveguides to the device. Each silicon waveguide is coupled at respective interfaces 104 to a III-V semiconductor based waveguide 102 which is within III-V device coupon 106. The coupon having been bonded to the silicon platform. The III-V semiconductor based waveguide 102 is, in this example, U-shaped and so allows for connection to the silicon waveguides 103a and 103b on a same side of the device coupon 106.

The device coupon 106 also includes a first 105a and second 105b electrical contact pads or electrodes. The electrical contact pads connect to different layers of a III-V semiconductor based device 110 in the III-V semiconductor based waveguide and, in use, are connected to a driver which operates the device. This operation may be performed at RF frequencies.

Figure 1B is a section view of the device 100 along the line A-B-C shown inn Figure 1A. The section view shows the III-V semiconductor based device 110 in more detail, and also shows the cladding layer 114 omitted from Figure 1A for reasons of clarity. The cladding layer is, in this example, formed of silicon dioxide (SiO₂). The cross-sectional structure of the silicon platform 101 is shown in more detail: a silicon substrate 117 is partially covered by a buried oxide layer 116, atop which are the silicon waveguides 103a and 103b.

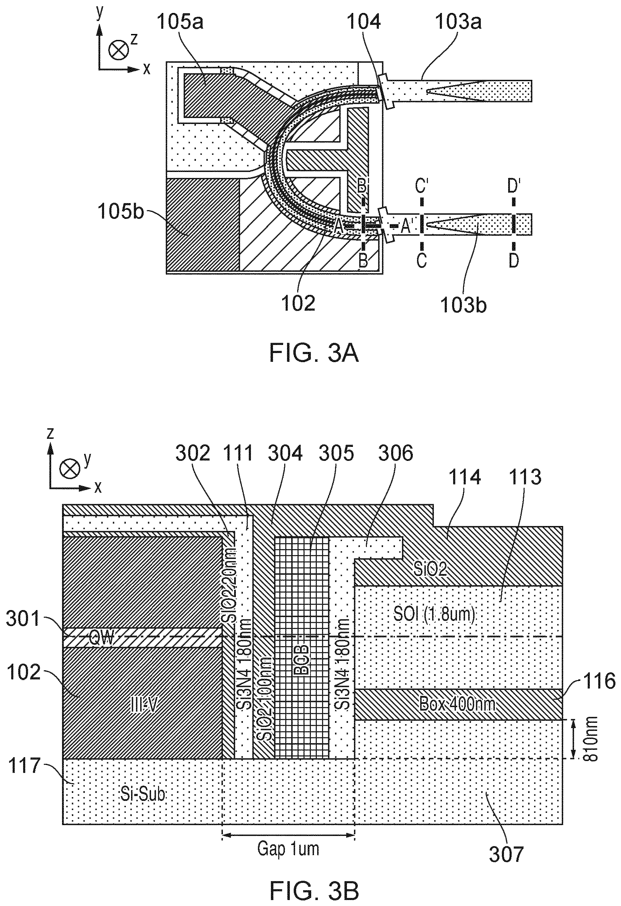

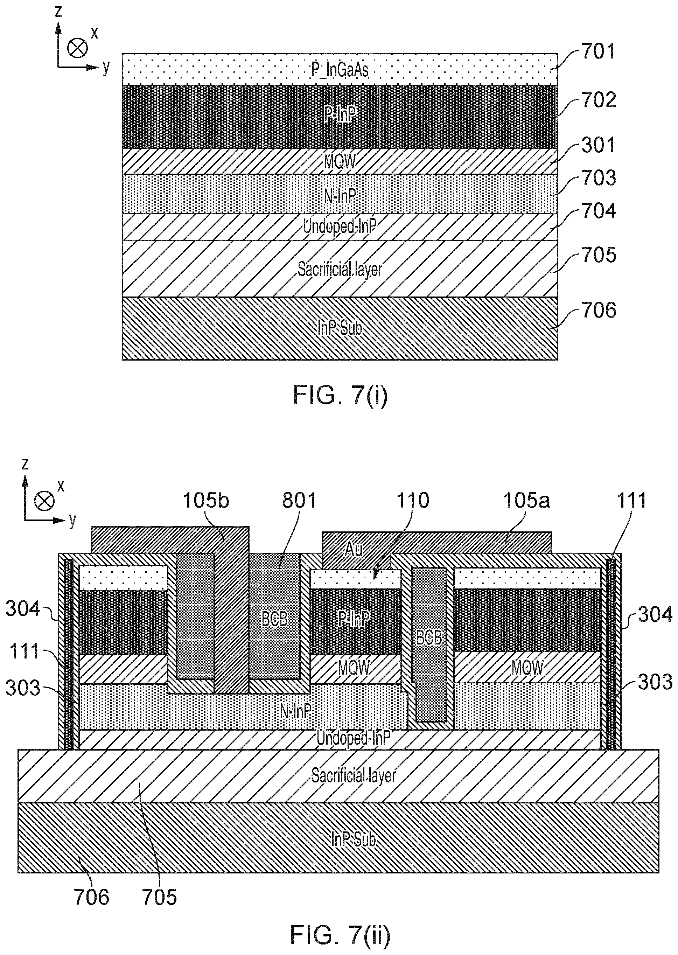

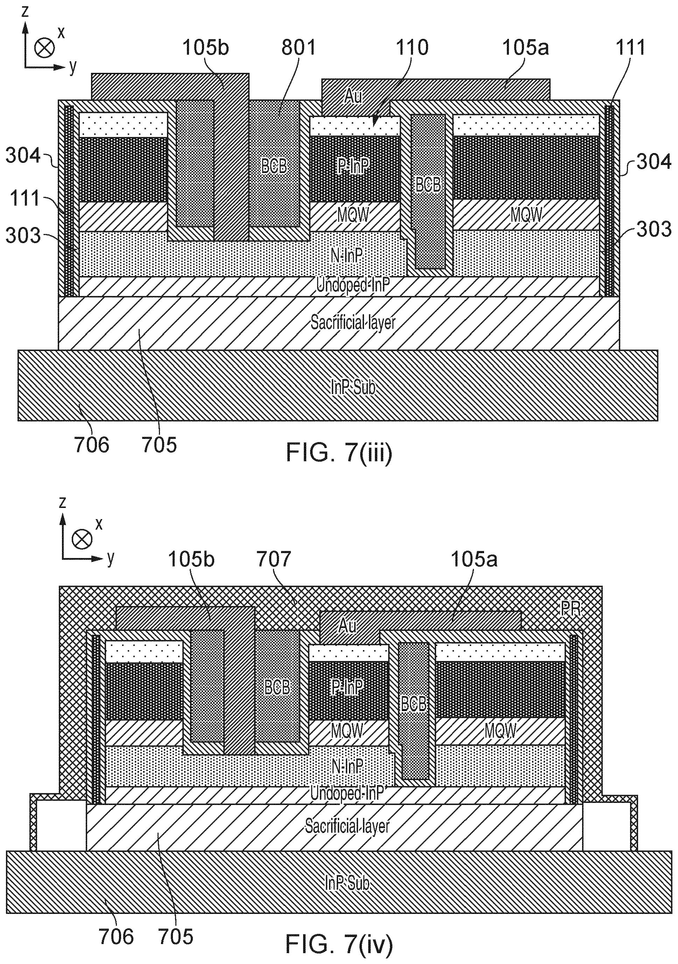

The plurality of layers forming the III-V semiconductor based device 110 can also be seen, the detail of which are discussed in detail with relation to Figure 7(i). The nature of interface 104 is also shown in more detail, and comprises: anti-reflective coating 111 and 306 and bridge fill 112. The anti-reflective coatings are provided on the device coupon 106, as well as the silicon platform 101. The space between the anti-reflective coatings is filled by bridge fill 112 which is formed of a polymer. More detail relating to the interface 104 is shown in and discussed with relation to Figures 3B, 4A, 4B, and 5 respectively.

The anti-reflective coating 111 on the silicon platform 101 enhances the coupling from the III-V semiconductor based waveguide 102 into a 1800 nm section 113 of the silicon waveguide 103a. This 1800 nm section tapers to a 3000 nm section 115 for transmission to or from the device 100. In an example then where silicon waveguide 103a is the input waveguide, an optical signal is received into the 3000 nm section 115, and is converted to a mode confined within the 1800 nm section 113 before transmission into the III-V semiconductor based waveguide 104.

As can be seen in Figure 1B, a gap exists between the silicon platform and the device coupon which has been filled by bridge fill 112, in this example Benzocyclobutene (BCB). The thickness of the gap varies as a function of position along the perimeter of the device coupon 106. At positions distal to the interfaces 104, the gap can be as wide as 20 µm as shown in Figure 1B. Whereas, at positions proximal to and including the interfaces 104, the gap may be as narrow as (or narrower than) 1 µm. In this example, a height, x, from the bottommost portion of the bridge fill 112 to a bottommost portion of the buried oxide layer is around 810 nm (the buried oxide layer having a height of around 400 nm). Where the buried oxide layer has a height of around 1 µm, the height x may be around 210 nm.

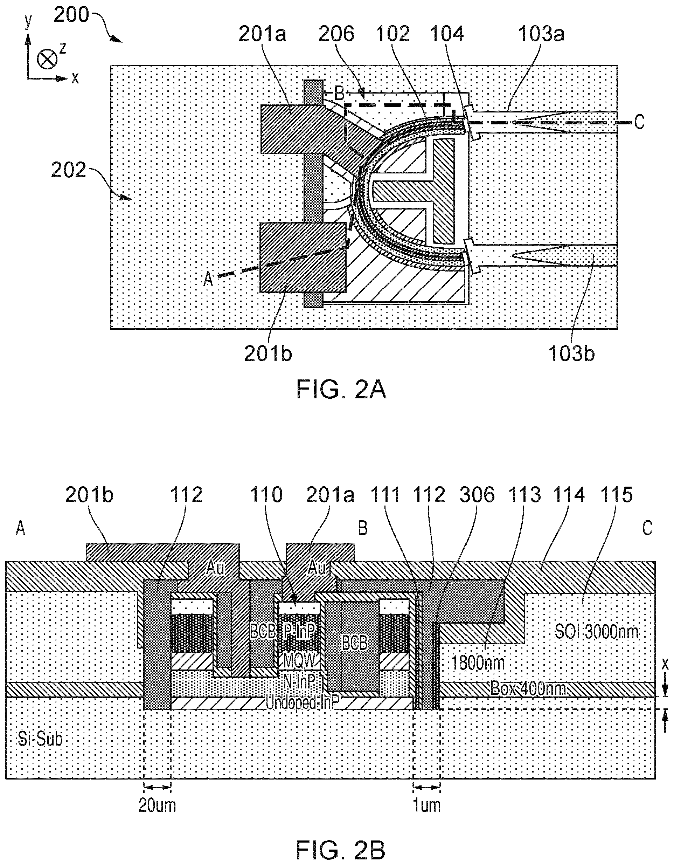

Figure 2A and 2B show, respectively, a top-down and section view of a variant optoelectronic device 200 according to an embodiment of the present invention. Where this embodiment shares features with the device 100 discussed above, like features are indicated by like reference numerals. The device 200 in Figures 2A and 2B chiefly differs from the earlier device in that contact pads 201a and 201b extend across the device coupon 206 to the silicon platform 202. This has the advantage that a smaller parasitic capacitance is experienced in use, and so the device speed is enhanced.

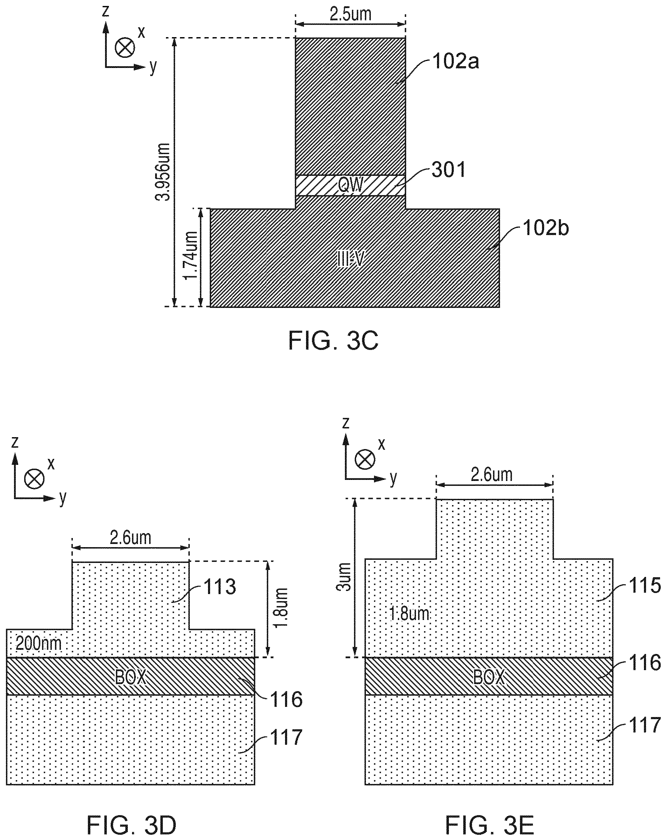

Figure 3A - 3E show, respectively, a top-down view and sections view of a III-V waveguide and SOI waveguide interface according to embodiments of the present invention. Whilst the example shown in Figure 3A, a top-down view, is device 100, the interface shown has the same structure when implemented in device 200. Figure 3B is a section view along the line A-A', Figure 3C is a section view along the line B-B', Figure 3D is a section view along the line C-C'; and Figure 3E is a section view along the line D-D'.

In Figure 3B, light is guided along the 'x' direction either from the 1.8 µm silicon waveguide 113 into the III-V semiconductor waveguide 102 or vice versa. As can be seen, the gap between the III-V semiconductor waveguide 102 and the 1.8 µm silicon waveguide has the following structure, in layers along the 'x' direction: 20 nm silicon dioxide layer 302; 180 nm anti-reflective silicon nitride, Si₃N₄, layer 111; 100 nm silicon dioxide layer 304; BCB fill 305; and 180 nm anti-reflective silicon nitride, Si₃N₄, layer 306. The 20 nm silicon dioxide layer 302 has a refractive index of around 1.45. The silicon nitride layer 111 has a refractive index of around 1.995, and the 100 nm silicon dioxide layer 304 has a refractive index of around 1.45. The 180 nm Si₃N₄ layer 306 has a refractive index of around 2.28 and, in this embodiment, with a composition slightly different to layer Si₃N₄ layer 111. However, the refractive index of the Si₃N₄ layers, 111 and 306, can be the same, either 1.995 or 2.28 with slight adjustment to their thickness. The entire gap has a width of around 1 µm. The entire anti-reflective coating, formed of layers 302, 111, 304, and 306 has a thickness of around 480 nm. The BCB fill has a refractive index of around 1.56. All of these refractive indexes are quoted for light at a wavelength of around 1310 nm.

The combination of these layers, in this fashion, have been found to enhance the coupling efficiency from the III-V semiconductor waveguide 102 to the 1.8 µm silicon waveguide 113.

Also shown in this view is silicon substrate portion 307, which extends part way up the cavity within which the device coupon sits. The height of this portion is around 810 nm. An optically active layer 301 of the Ill-V semiconductor based waveguide 102 can also be seen, in this example a multiple quantum well.

Figure 3C is a cross-section along the line B-B' in Figure 3A. The structure of the III-V semiconductor based waveguide 102 can be seen in greater detail. Broadly, the waveguide includes a waveguide slab or base 102b, and a ridge or rib 102 extending therefrom. Between the slab and rib, or forming a part of the rib, is the optically active layer 301. The slab, in this example, has a height of around 1.74 µm, whereas the rib has a height of around 3.956 µm. The rib has a width of around 2.5 µm.

Figure 3D is a cross-section along the line C-C' in Figure 3A. The structure of the 1.8 µm silicon waveguide 113 can be seen in greater detail. Broadly, the waveguide includes a slab or base, and a ridge or rib. The slab is around 200 nm tall, whereas the rib is around 1.8 µm tall and around 2.6 µm wide. Figure 3E is a cross-section along the line D-D' in Figure 3A. The structure of the 3µm silicon waveguide 115 can be seen in greater detail. Broadly, the waveguide includes a slab or base and a ridge or rib. The slab is around 1.8 µm tall, whereas the rib is around 3 µm tall and around 2.6 µm wide. Herein, the height of a feature is typically measured from an uppermost surface of the buried oxide layer 116 to an uppermost surface of that feature. The height of the rib and slab in the 1.8 µm waveguide 113 tapers to the height in the 3 µm waveguide, such that the tapered region functions as a mode converter between the 1.8 µm waveguide and 3 µm waveguide.

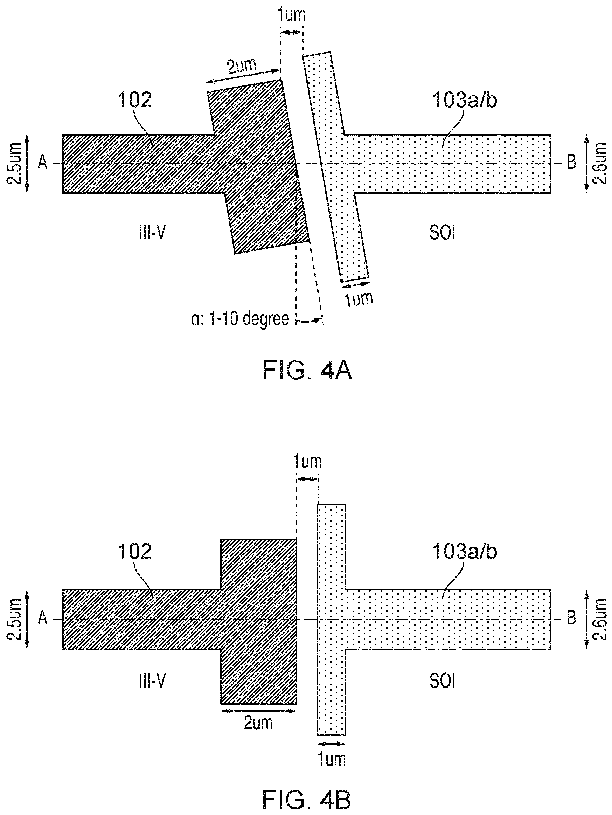

Figure 4A and 4B show schematic views top-down views of variant interfaces. In the example shown in Figure 4A, which is the interface implemented in Figures 1A and 2A, the interface between the III-V semiconductor based waveguide 102 and the silicon waveguides 103a/b is at an angle a relative to the guiding direction (A-B, or vice versa). The angle α typically takes a value of between 1° and 10° inclusive. Also shown in Figure 4A is the 'T' geometry of the interfaces. The 'bar' of the T in the III-V semiconductor waveguide, i.e. the portion which extends at the angle α, has a width of around 2 µm. The 'bar' of the T in the silicon waveguide, again the portion which extends at the angle α, has a width of around 1 µm. A gap between the respective T interfaces is around 1 µm.

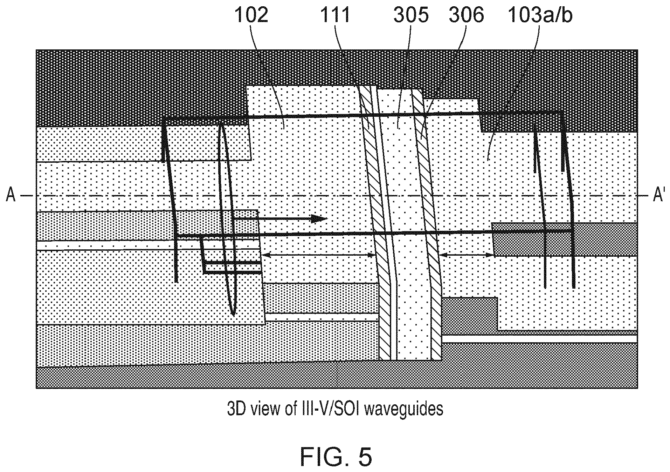

Figure 4B is a top-down schematic of a variant interface, which may be used in place of the interface shown in Figure 4A. Whilst it is still 'T' shaped in geometry, in the example shown in Figure 4B there bars of the T are not angled relative to the guiding direction (A-B). Figure 5 show further detail of the interface and coupling structure. Figure 5 is a 3D perspective view of the interface between the III-V semiconductor based waveguide 102 and the silicon waveguides 103a/b.

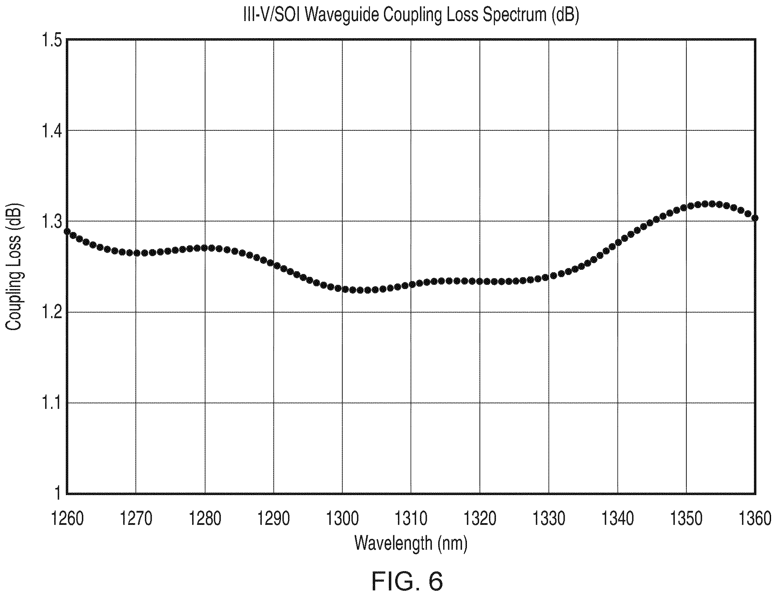

Figure 6 is a plot of coupling loss (dB) against wavelength (nm) for a simulated bridge and coupling structure. Notably, the plot shows that the optical coupling loss over the O-band (around 1260 nm to around 1360 nm) is between 1.22 and 1.32 dB.

Figures 7(i) to 7(vi) show various manufacturing stages of a device coupon according to an embodiment of the present invention. In the step shown in Figure 7(i), a III-V semiconductor based stack is provided. In the example shown, the stack comprises the following layers (from an uppermost layer to a lowermost layer):
701 - P-doped InGaAs layer;
702 - P- doped InP layer;
301- Multiple quantum well layer;
703 - N-doped InP layer;
704 - Undoped InP layer;
705 - Sacrificial layer; and
706 - InP substrate layer.

In another example, the stack has the following layers:

**Table 1**

| Layer | Multiplier | Material | Composition | Wavelength (nm) | Thickness (nm) | Doping (cm⁻³) |
|---|---|---|---|---|---|---|
| 19 | | InGaAs | Lattice match to InP | | 120+30 | 1×10¹⁹ CBr+Zn |
| 18 | | InGaAsP | | 1100 | 50 | 1.5×10¹⁸Zn |
| 17 | | InP | - | - | 1340 | 1×10¹⁸ Zn |
| 16 | | InGaAsP | | 1100 | 20 | 1×10¹⁸ Zn |
| 15 | | AllnAs | | | 60 | 1×10¹⁷ to 1×10¹⁸ Zn |
| 14 | | AllnAs | | 843 | 60 | 1×10¹⁷ Zn |
| 13 | | ALInGaAs | | 968 | 70 | |
| 12 | 12x | AlInGaAs | | 1127 | 7 | |
| 11 | 12x | AlInGaAs | | 1245 | 9 | |
| 10 | | AlInGaAs | | 1127 | 7 | |
| 9 | | InGaAsP | | 1100 | 117 | |
| 8 | | InP | - | - | 80 | 2×10¹⁷ Si |
| 7 | | InP | - | - | 70 | 5×10¹⁷ Si |
| 6 | | InP | - | - | 920 | 8×10¹⁷ Si |
| 5 | | InGaAsP | Lattice Match to InP | 1100 | 20 | Undoped |
| 4 | | InP | | | 800 | Undoped |
| 3 | | InGaAs | | | 50 | Undoped |
| 2 | Release | AlInAs | | | 500 | Undoped |
| 1 | Buffer | InP | | | 50 | Undoped |
| 0 | InP Substrate | | | | | |

Where layer 4 forms the bottom surface layer of the device coupon once separated from the InP substrate, and layers 3 and 2 are sacrificial layers used in the release of the coupon from the substrate.

These layers can be provided, for example, through molecular beam epitaxy or chemical vapour deposition. Once provided, through standard fabrication processes (e.g. etching, deposition, and masking) a III-V electro-absorption modulator (EAM) structure can be fabricated. The result of this is shown in Figure 7(ii). The structure includes the IlI-V semiconductor based device 110 discussed previously. An upper layer of which is electrically connected to the first electrical contact pad 105a, and a lower layer of which (N-InP layer) is electrically connected to the second electrical contact pad 105b.

Also of note, is that the anti-reflective coating (ARC) formed of the SiO₂ layer 303, Si₃N₄ layer 111, and second SiO₂ layer 304 are formed as a part of the device coupon manufacture. The ARC also functions then as a facet protection coating for the sacrificial release layer etching process discussed below. The structure includes, as a fill e.g. between the III-V semiconductor based device 110 and peripheral components, a BCB fill 801. The use of BCB takes advantage of its relatively low dielectric constant, which can reduce parasitic capacitance and so provide a higher operating speed.

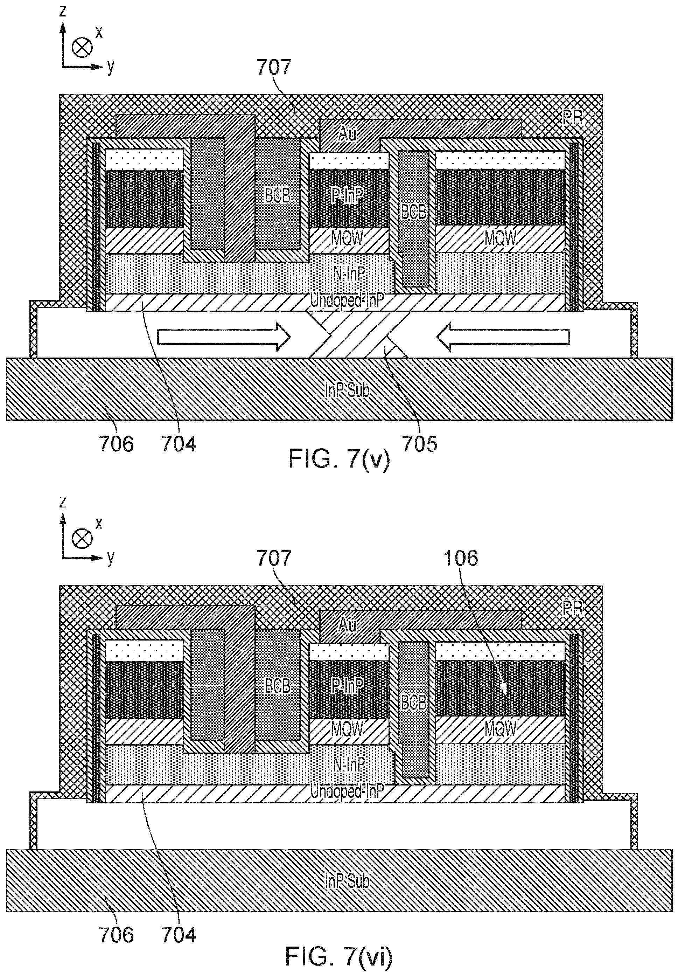

Next, in a step the results of which are shown in Figure 7(iii), a dry etching process is performed to remove the portions of the sacrificial layer 705 which have an exposed upper surface. That is, the portions of the sacrifice layer which extend laterally beyond the ARC are removed as shown in Figure 7(iii). This step 'releases' the multi-layered stack, in that it is ready for subsequent processing. An upper surface of the InP substrate is thereby exposed, as are lateral sides of the sacrifice layer 705. Subsequently, in a step shown in Figure 7(iv), a photoresist tether (PR) 707 is applied to the outside of the device coupon, at least partially covering the coupon sidewall, the ARC and upper surfaces. Notably, the lateral sides of the sacrificial layer 705 remain exposed (the result of the partial coverage of the coupon sidewall and the ARC).

After this, in a step show in Figure 7(v), a wet etch process is started to begin removing the sacrificial layer 705. The etch proceeds in the direction shown, i.e. laterally towards the centre of the coupon from the periphery thereof. When the wet etch process is completed, a structure shown in Figure 7(vi) results. The coupon 106 is suspended by the photoresist 707 above the InP substrate 704, with the lowermost surface of the undoped InP layer 704 facing the uppermost surface of the substrate. The device coupon is then ready for transfer printing.

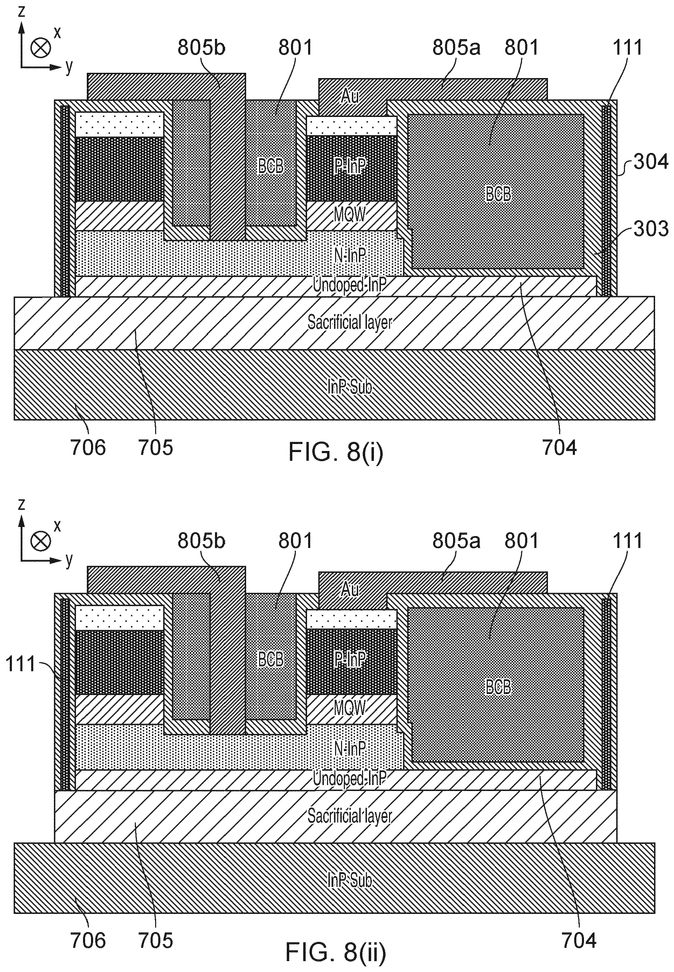

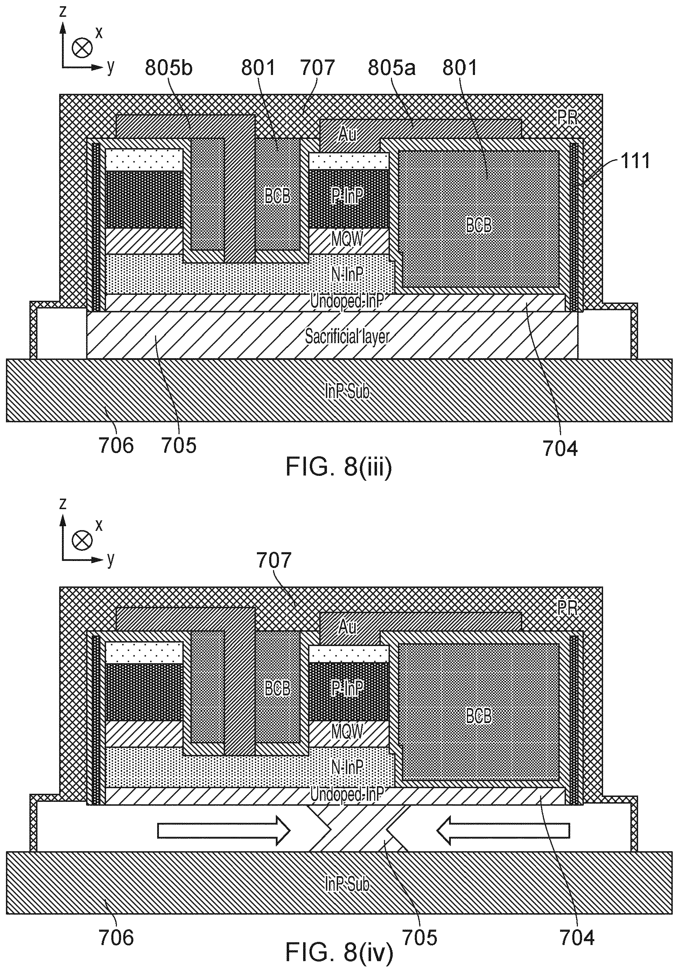

Figures 8(i) to 8(v) show various manufacturing stages of a variant device coupon according to an embodiment of the present invention. The method shown in Figures 8(i) to 8(v) starts after the step shown in Figure 7(i); that is the provision of a multi-layered epitaxial stack formed of III-V semiconductor layers. In a step the results of which are shown in Figure 8(i), standard fabrication processes (e.g. etching, deposition, and masking) a variant III-V electro-absorption modulator (EAM) structure can be provided. The structure in Figure 8(i) differs from that in Figure 7(ii) in that electrode traces 805a and 805b are provided which will electrically connect to contact pads which extend at least partially onto the silicon platform (as discussed previously in relation to Figures 2A and 2B).

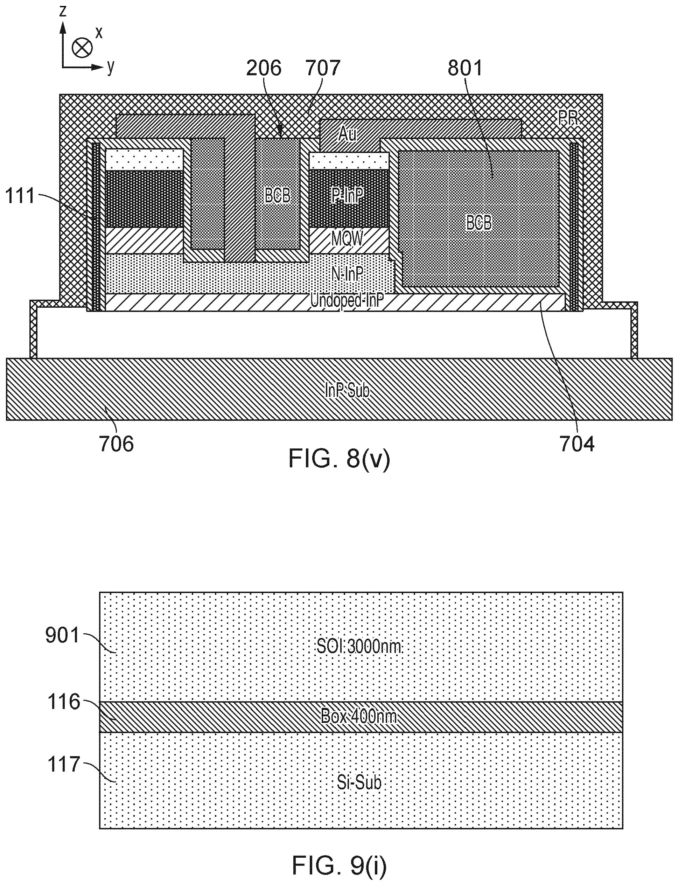

After the step shown in Figure 8(i), a dry etch process is performed to remove the portions of the sacrificial layer 705 which have an exposed upper surface. The result of this is shown in Figure 8(ii). An upper surface of the InP substrate 706 is thereby exposed, as are lateral sides of the sacrificial layer 705. Subsequently, in a step shown in Figure 8(iii), a photoresist tether 707 is applied to the outside of the device coupon, at least partially covering the ARC and upper surfaces. Notably, the lateral sides of the sacrificial layer 705 remain exposed (the result of the partial coverage).

After this step, in a step shown in Figure 8(iv), a wet etch process is started to begin removing the sacrificial layer 705. The etch proceeds in the direction shown, i.e. laterally towards the centre of the coupon from the periphery thereof. When the wet etch process is completed, a structure shown in Figure 8(v) results. The coupon 206 is suspended by the photoresist 707 above the InP substrate 704, with the lowermost surface of the undoped InP layer 704 facing the uppermost surface of the substrate. The device coupon is then ready for transfer printing.

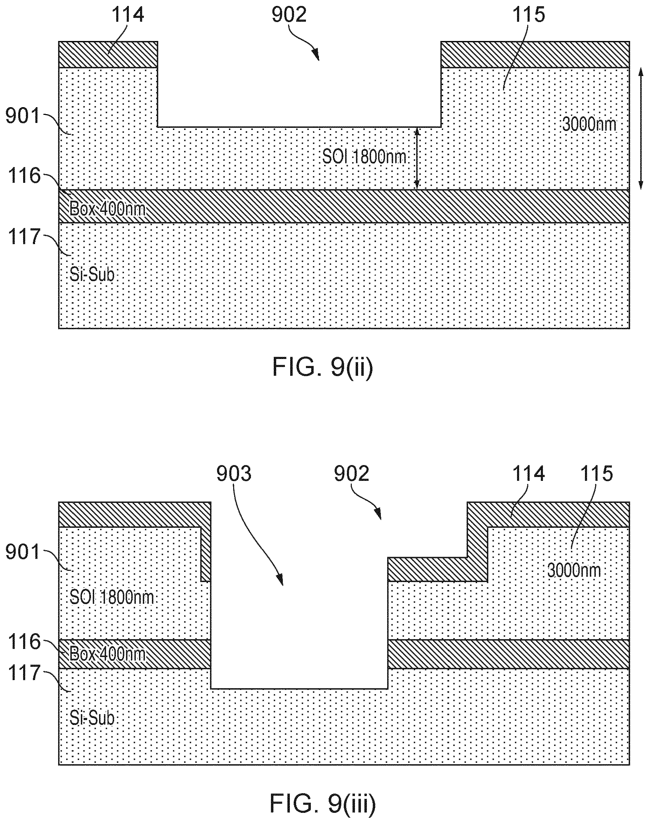

Figures 9(i) to 9(v) show various manufacturing stages of a silicon platform according to an embodiment of the present invention. In a first step, shown in Figure 9(i), a silicon-on-insulator wafer is provided. A silicon device layer 901, which is around 3000 nm or 3 µm tall, is above a 400 nm buried oxide (e.g. SiO₂) layer 116. The buried oxide layer is above the silicon substrate 117.

Next, in a step the results of which are shown in Figure 9(ii), a first cavity 902 is etched into the silicon device layer. A part of this step includes the deposition of cladding layer 114 (formed here of silicon dioxide). The first cavity is etched so that a 1800 nm portion of the silicon device layer remains above the buried oxide layer. This etch also provides the 3 µm to 1800 µm waveguide taper discussed previously, which functions as a mode converter for light passing through the taper.

After the taper has been provided, a second etch is performed to form second cavity 903. This second cavity extends through the buried oxide layer and partially into the silicon substrate. The exact depth of the etch is chosen such that an optical mode supported by the 1800 nm silicon waveguide 113 is generally aligned with an optical mode supported by the III-V semiconductor based waveguide 102 (when present in the cavity 903). The surface roughness (e.g. Rₐ, R_{z}, or R_{MAX}) of the bed of the second cavity is preferably at a sub nanometre level, as measured using an atomic force microscope. The measured area is typically around 10 µm by 10 µm.

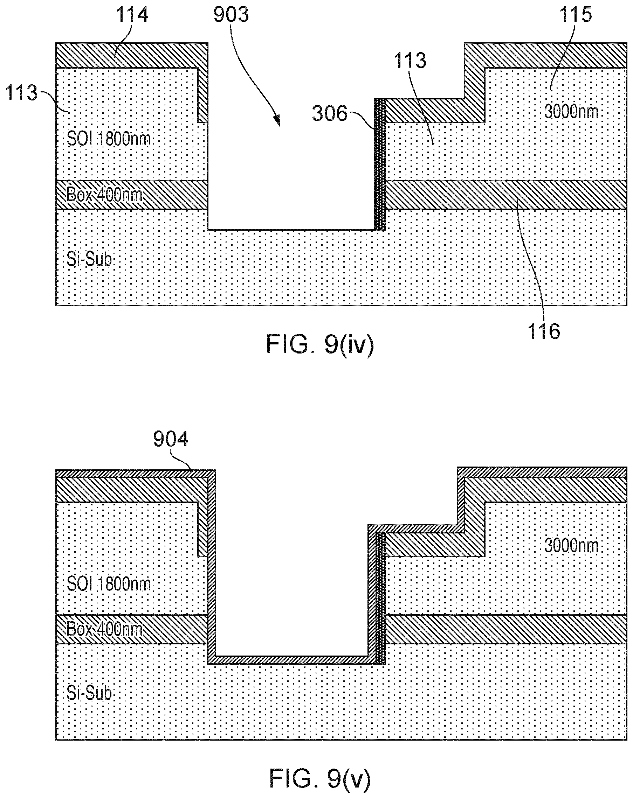

Next, in a step shown in Figure 9(iv) the 180 nm Si₃N₄ anti-reflective coating is provided on one or more sidewalls of the cavity 903. The silicon platform is then ready for micro-transfer printing. Figure 9(v) shows an optional further step, where an adhesive layer 904 (such as BCB) is spun-coated onto the silicon platform. The adhesive layer is between 30 nm and 100 nm thick.

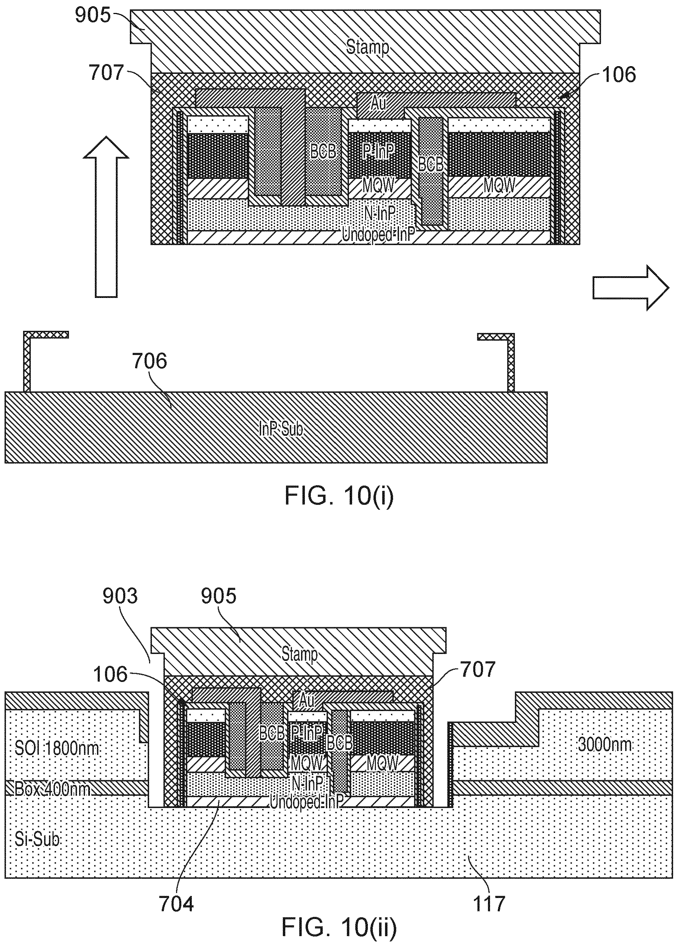

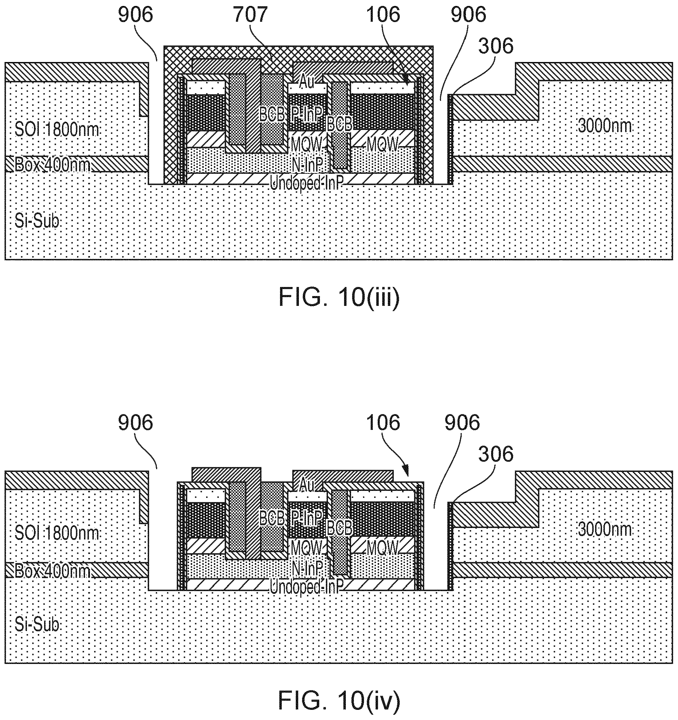

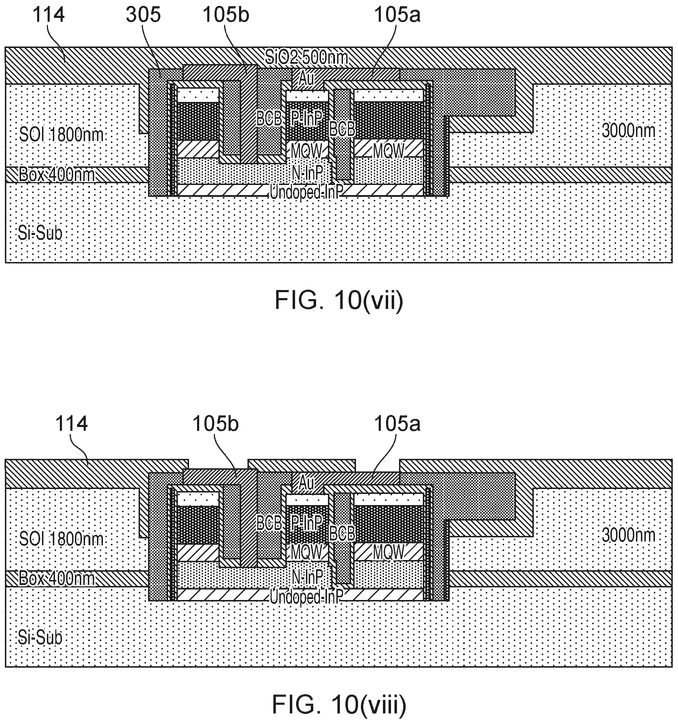

Figures 10(i) to 10(viii) show various manufacturing stages of an optoelectronic device according to an embodiment of the present invention. In a first step, shown in Figure 10(i) a stamp (in some examples an elastomer stamp) is used to pick up the device coupon 106 by attaching to the photoresist tether 707. In a first movement, indicated by the left-hand arrow in Figure 10(i), the stamp and device coupon 106 are lifted up and away from the InP substrate 706 which breaks the tethers. Subsequently, the stamp and device coupon are moved laterally towards the silicon platform.

Next, in a step shown in Figure 10(ii), the device coupon 106 is deposited into the second cavity 903 formed in the silicon platform earlier. This deposition step includes aligning the III-V semiconductor based waveguide 102 within the device coupon 106 with the 1800 nm silicon waveguide. Once deposited, a lowermost surface of the undoped InP layer 704 directly abuts an upper surface of the silicon substrate layer 117 (asides from examples where an adhesive 904 is used, in which case the adhesive will sit between the undoped InP layer and the silicon substrate).

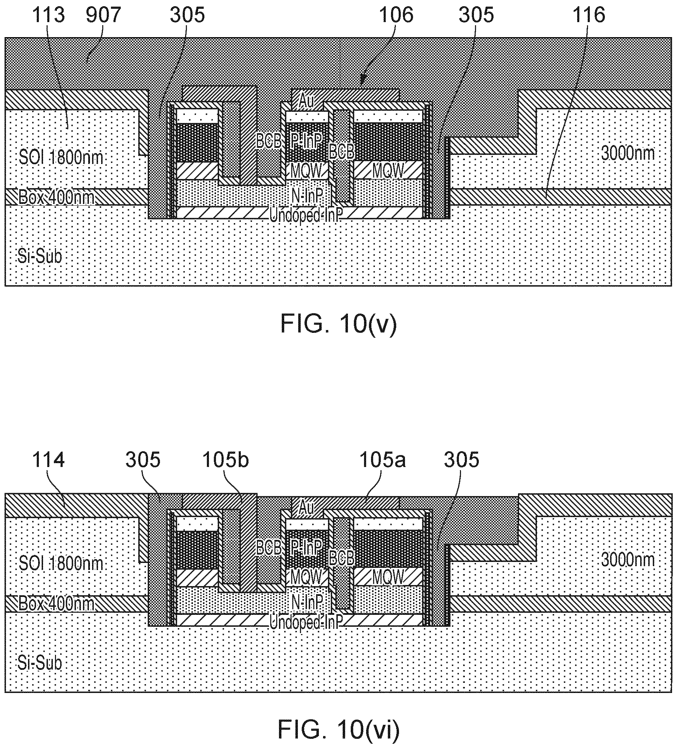

Subsequently, in a step shown in Figure 10(iii) the stamp is released and the device coupon 106 is left within the cavity 903. Once the stamp has been released, the photoresist 707 is then removed using a dry etching process. The combination of device coupon 106 and silicon platform is then annealed at a temperature of between 280°C and 300°C inclusive for at least 1 and no more than 15 hours. The result of this processing is shown in Figure 10(iv). Also of note, in Figure 10(iv) is channel 906 which surround a periphery of the device coupon 106 between the device coupon and the sidewalls of the cavity 903. The channel 906 thereby defines a boundary around the device coupon 106.

After the annealing step, the combination of device coupon 106 and silicon platform is then spun coated with a polymer 907 (in this example Benzocyclobutene) and thermally cured at around 280°C for around 60 minutes in a nitrogen atmosphere (N₂). The result of this spin coating step is shown in Figure 10(v). Notably the spun coated BCB 907 fills the channel 906 and provides the bridge fill 305 discussed previously.

After the thermal curing process has completed, the polymer 907 is etched back in a dry etch step (using, for example, O₂ CF₄, or SF₆ gas) such that the upper surface of contact pads 105a and 105b are exposed, as well as cladding layer 114. The result of this is shown in Figure 10(vi). As an alternative, photosensitive BCB can be used for the channel 906 filling. In this case, the photosensitive BCB functions like a negative photoresist. The upper surface of contact pads 105a and 105b can be exposed after the BCB spin coating, UV exposure and develop followed by the thermal curing process. Subsequently, further cladding layer 114 is added as shown in Figure 10(vii) to isolate the bridge fill 305 from moisture. This cladding layer, in some examples formed from SiO₂, has a thickness of around 500 nm. Finally, in a step shown in Figure 10(viii), vias are opened in the cladding layer above the contact pads 105a and 105b for wire bonding.

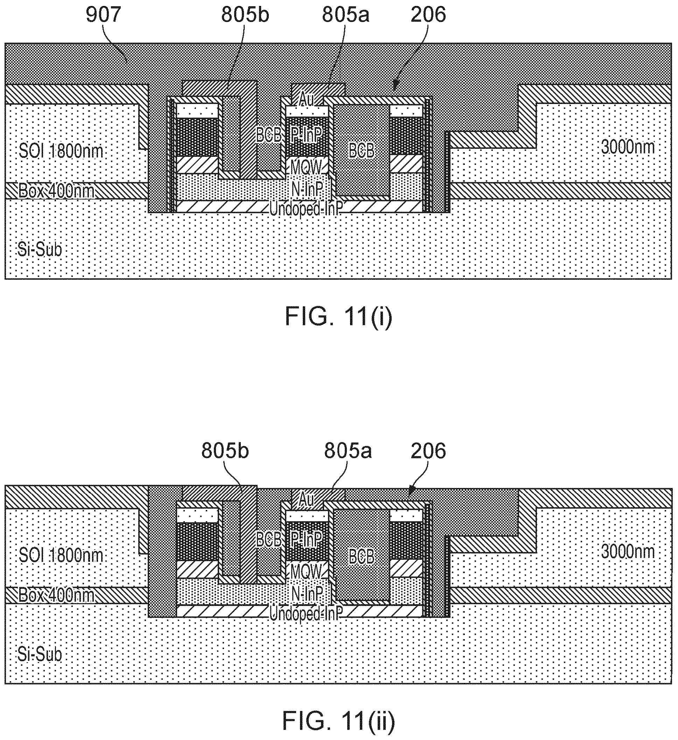

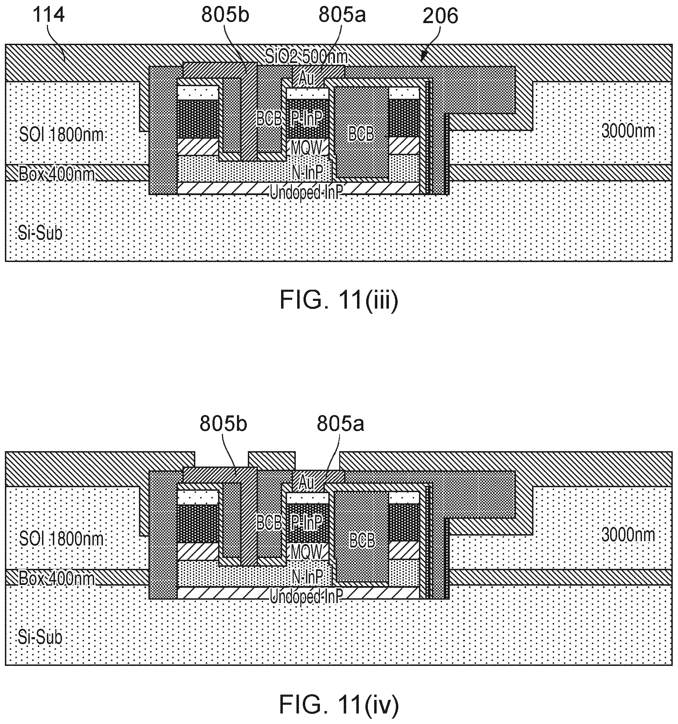

Figures 11(i) to 11(v) show various variant manufacturing stage of an optoelectronic device according to an embodiment of the present invention. The steps shown in Figures 10(i) to 10(v) are repeated using the device coupon 206 discussed with relation to Figures 8(i) to 8(v). The result, as shown in Figure 11(i) is a device coupon 206 which has been bonded to the silicon substrate of the silicon platform. The spun coated polymer 907 again fills the channels 906, and the device has been thermally cured at around 280°C for around 60 minutes in a nitrogen atmosphere (N₂).

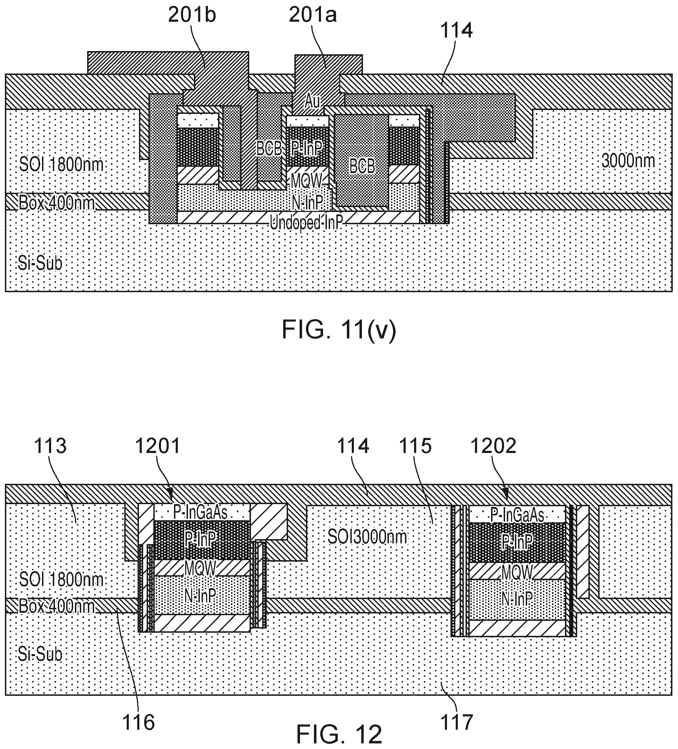

Next, as shown in Figure 11(ii) an etching and/or planarization process is performed so that the upper surface of wire traces 805b and 805a are exposed. As an alternative, photosensitive BCB can be used for the channel 906 filling. In this case, the photosensitive BCB functions like a negative photoresist. The upper surface of contact pads 105a and 105b can be exposed after the BCB spin coating, UV exposure and develop followed by the thermal curing process. After this further cladding material is deposited to provide a 500 nm thick SiO₂ cladding layer 114, as shown in Figure 11(iii). After this deposition, vias are opened in the cladding layer 114 above the traces 805a and 805b. The result of this is shown in Figure 11(iv). This allows for a metallization process to provide contact pads 201a and 201b, which extend at least partially over the silicon platform. The device is then ready for wire bonding and operation.

Figure 12 shows a section view of two optoelectronic devices on a single silicon platform according an embodiment of the present invention. In this example, three cavities are formed: a first cavity at least partially defining a 1800 nm silicon waveguide; a second cavity within which a III-V semiconductor based electro-absorption modulator 1201 has been printed; and a third cavity adjacent to a 3000 nm silicon waveguide 115 within which a III-V semiconductor based laser 1202 has been deposited. The III-V semiconductor based electro-absorption modulator 1201 is optically coupled to a first and second 1800 nm silicon waveguide 113. In use, laser 1202 produces an optical signal which is coupled into the 3000 nm silicon waveguide 115, a taper in or between the 3000 nm and 1800 nm silicon waveguides coverts the optical mode to one which is couplable into the EAM 1201. The EAM 1201 imparts a modulation profile to the signal, which is then coupled into 1800 nm silicon waveguide 113 for further transmission.

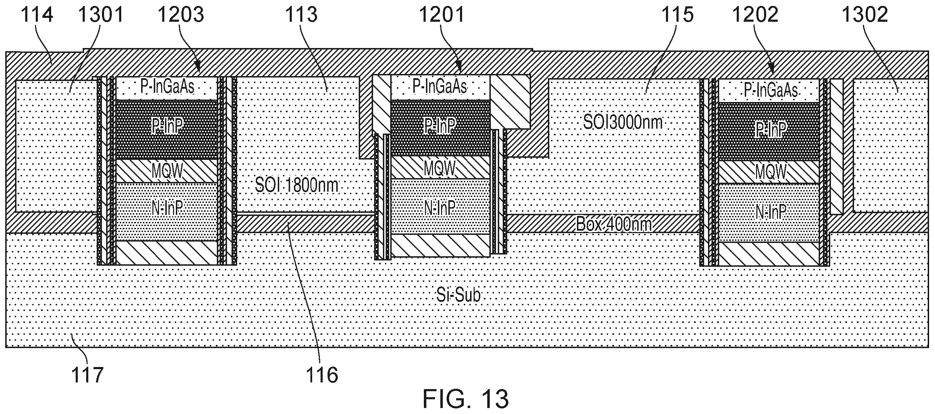

Figure 13 shows a section view of three optoelectronic devices on a single silicon platform according to an embodiment of the present invention. The arrangement in Figure 13 differs from that in Figure 12 in that it further includes a semiconductor optical amplifier, SOA, 1203, which is located in a fourth cavity. The SOA is configured to receive signals from the EAM, via 1800 nm silicon waveguide 113, and amplify them before coupling them into output waveguide 1301.

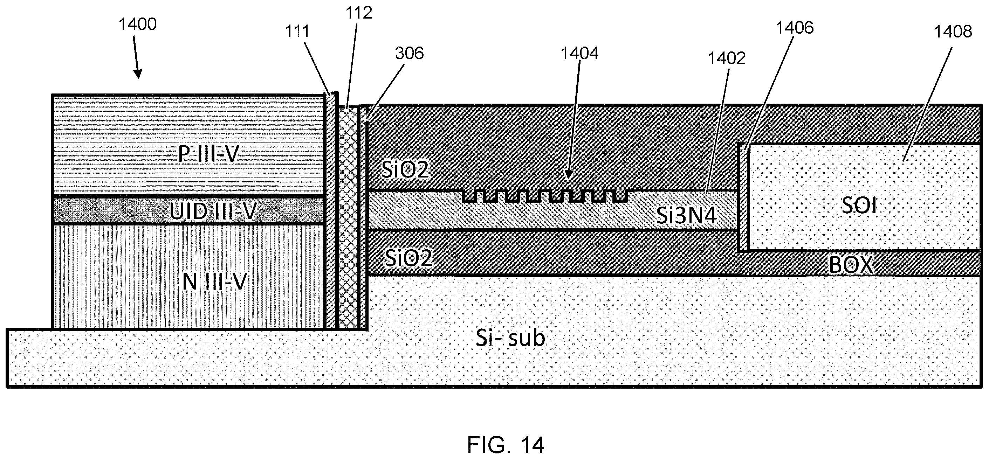

Figure 14 shows a section view of a variant optoelectronic device according to an embodiment of the present invention. A photonic component 1400, of the type discussed previously, has been bonded to a bed of a cavity formed in silicon substrate Si-sub of a silicon platform. The silicon platform includes a silicon nitride (Si₃N₄) waveguide 1402, in which is a Bragg grating 1404. The silicon nitride waveguide 1402 is coupled to the photonic component as well as a silicon waveguide 1408 formed in a silicon on insulator layer. Between the silicon nitride waveguide 1402 and silicon waveguide 1408 is an antireflective coating 1406. Between the photonic component 1400 and the silicon nitride waveguide 1402 are antireflective coatings 111 and 306 as well as the bridge fill 112.

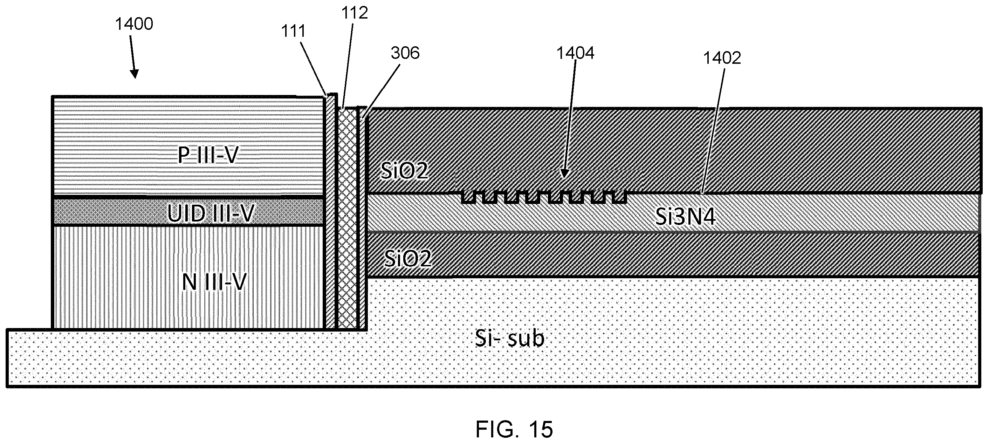

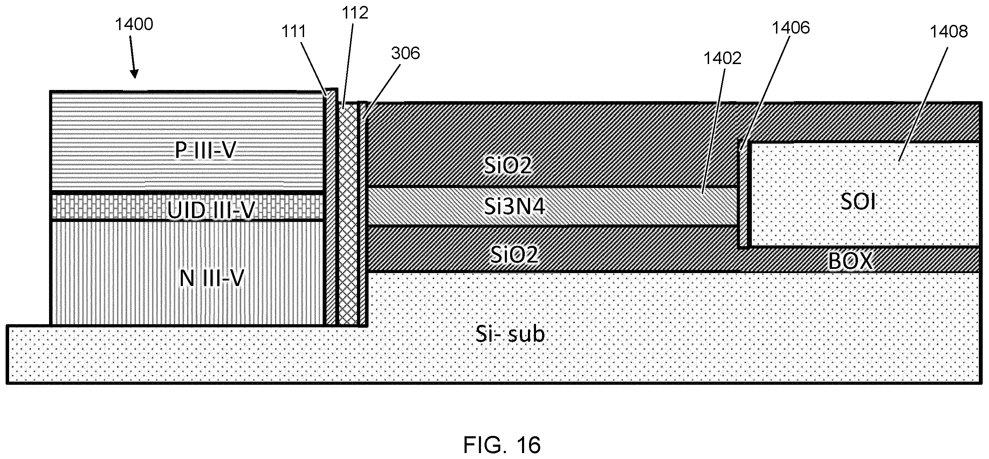

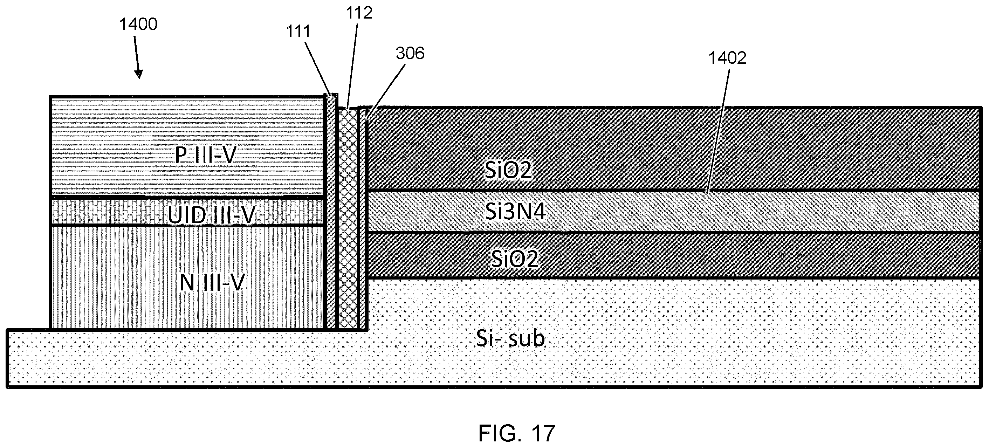

Figure 15 shows a section view of a variant optoelectronic device according to an embodiment of the present invention. It differs from the embodiment shown in Figure 14 in that there is no silicon waveguide formed in a silicon device layer. Instead the photonic component only couples to silicon nitride waveguide 1402. Figure 16 shows a section view of a variant according to an embodiment of the present invention. It differs from the embodiment shown in Figure 14 in that the silicon nitride waveguide 1402 does not contain a Bragg grating. Figure 17 shows a variant optoelectronic device according to an embodiment of the present invention. It differs from the embodiment shown in Figure 14 in that it does not include a silicon waveguide formed in a silicon device layer and it does not include a Bragg grating in the silicon nitride waveguide 1402.

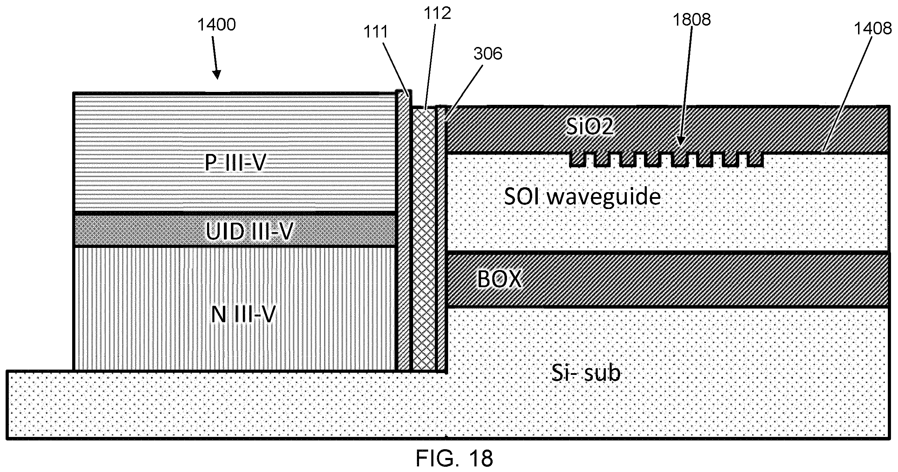

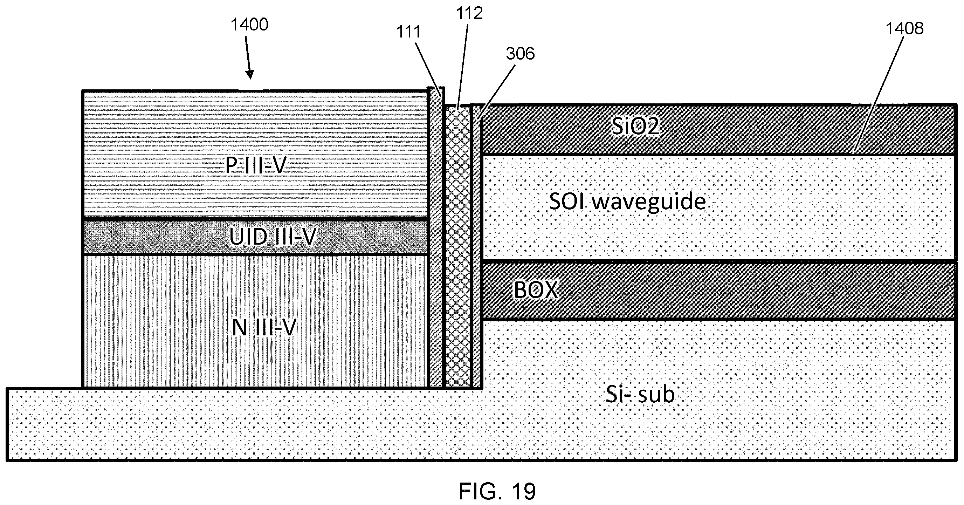

Figure 18 shows a section view of a variant optoelectronic device according to an embodiment of the present invention. A photonic component 1400, of the type discussed previously, has been bonded to a bed of a cavity formed in silicon substrate SI-sub of a silicon platform. The silicon platform includes a silicon waveguide 1408 formed in a silicon on insulator layer, and the silicon waveguide 1408 includes a Bragg grating 1808. The silicon waveguide is coupled to the photonic component via antireflective coatings 111 and 306 as well as bridge fill 112. Figure 19 shows a schematic view of a variant optoelectronic device according to an embodiment of the present invention. It differs from the embodiment shown in Figure 18 in that the silicon waveguide 1408 does not contain a Bragg grating.

While the invention has been described in conjunction with the exemplary embodiments described above, many obvious modifications and variations will be apparent to those skilled in the art when given this disclosure. Accordingly, the exemplary embodiments of the invention set forth above are considered to be illustrative and not limiting.

### List of Features

| | | | |
|---|---|---|---|
| 101, 202 | Silicon platform | 1201 | EAM |
| 102 | III-V semiconductor based waveguide | 1202 | Laser |
| 103a/b | Silicon waveguide | 1203 | SOA |
| 104 | Waveguide interface | 1301 | Output waveguide |
| 105a/b | Contact pads | 1400 | Photonic component |
| 106, 206 | III-V device coupon | 1402 | SiN3 waveguide |
| 110 | III-V semiconductor based photonic component | | |
| 111 | Anti-reflective coating | 1404 | SiN Grating |
| 112 | Bridge fill | 1408 | SOI waveguide |
| 113 | 1800 nm silicon waveguide portion | 1808 | Si Grating |
| 114 | Cladding layer | | |
| 115 | 3000 nm silicon waveguide portion | | |
| 116 | Buried oxide layer | | |
| 117 | Silicon substrate | | |
| 201a/b | Contact pads | | |
| 301 | Multiple quantum well (QMW) layer | | |
| 302 | First silicon dioxide liner | | |
| 304 | Second silicon dioxide liner | | |
| 305 | BCB bridge fill | | |
| 306 | Second silicon nitride liner | | |
| 307 | Silicon substrate portion | | |
| 102a | III-V waveguide ridge | | |
| 102b | III-V waveguide slab | | |
| 701 - 706 | III-V semiconductor layers | | |
| 707 | Photoresist tether | | |
| 801 | BCB fill | | |
| 805a/b | Electrode trace | | |
| 901 | Silicon on insulator / device layer | | |
| 902 | First cavity | | |
| 903 | Bonding cavity | | |
| 904 | Adhesive | | |
| 905 | Stamp (elastomer) | | |
| 907 | Spun coated BCB | | |

## Claims

1. A method of manufacturing an optoelectronic device (100), the manufactured device including a photonic component (110) coupled to a waveguide (102), the method comprising:
providing a device coupon (106), the device coupon (106) including the photonic component (110);
providing a platform (101), the platform comprising a cavity (903) within which is a bonding surface for the device coupon (106);
transfer printing the device coupon (106) onto the cavity (903), such that a surface of the device coupon (106) directly abuts the bonding surface and at least one channel is present between the device coupon (106) and a sidewall of the cavity (903); and
filling the at least one channel with a filling material (907) via a spin-coating process, to form a bridge coupling the photonic component (110) to the waveguide (102).

2. The method of claim 1, further comprising a step of curing the filling material after it has been spun-coated.

3. The method of claim 1 or 2, wherein the device coupon (106) includes a first and second electrode (105a, 105b).

4. The method of any preceding claim, wherein a silicon waveguide (1408) is in a device layer (901) of a silicon-on-insulator wafer provided in the platform (101), the silicon waveguide directly abutting the cavity (903).

5. The method of claim 4, wherein the silicon waveguide includes a waveguide tapering in height in a direction towards the cavity (903), from a first height to a second height, the first height being greater than the second height.

6. The method of any preceding claim, wherein the silicon waveguide (102) includes a Bragg grating.

7. The method of any preceding claim, wherein the platform (101) has a silicon nitride waveguide (1402); wherein optionally the silicon nitride waveguide includes a Bragg grating.

8. The method of any preceding claim, wherein the photonic component (110) is made of:
III-V materials;
II-VI materials; or
group IV materials.

9. The method of any preceding claim, wherein the photonic component (110) comprises either: a regular quantum well; or
a triangle quantum well.

10. The method of any preceding claim, wherein the photonic component (110) is either:
a photodetector; or
an electro-absorption modulator, EAM, utilising the quantum confined stark effect, QCSE.

11. The method of any preceding claim 1 - 7, wherein the photonic component (110) is an electro-absorption modulator, EAM, utilising the Franz-Keldysh, FK effect.

12. The method of any preceding claim, further including a step, before filling the channel, of lining one or more sidewalls of the cavity with an anti-reflective liner; and/or
further including a step, before transfer printing the device coupon, of providing an anti-reflective coating around one or more lateral side of the device coupon.

13. The method of any preceding claim, wherein the filling material is a polymer, for example Benzocyclobutene, or the filling material is sol-gel.

14. An optoelectronic device (100), including:
a waveguide (102), provided in a device layer of a wafer;
a photonic component (110) of a device coupon (106), located within a cavity (903) of the wafer; and
a bridge, which optically couples the waveguide (102) at a sidewall of the cavity (903) to the photonic component (110);
wherein the bridge is at least partially formed of a filling material (907) that includes a polymer.

15. The optoelectronic device of claim 14, wherein the bridge also included one or more anti-reflective coatings,
wherein optionally the bridge includes a pair of anti-reflective coatings, located on opposing sides of the polymer; and
wherein further optionally one of the pair of anti-reflective coatings is formed of a layer of silicon nitride located between a pair of silicon dioxide layers.

## Patentansprüche

1. Ein Verfahren zum Herstellen einer optoelektronischen Vorrichtung (100), wobei die hergestellte Vorrichtung eine photonische Komponente (110) beinhaltet, die mit einem Wellenleiter (102) gekoppelt ist, wobei das Verfahren Folgendes umfasst:
Bereitstellen eines Vorrichtungscoupons (106), wobei der Vorrichtungscoupon (106) die photonische Komponente (110) beinhaltet;
Bereitstellen einer Plattform (101), wobei die Plattform einen Hohlraum (903) umfasst, in dem sich eine Bondingoberfläche für den Vorrichtungscoupon (106) befindet;
Transferdrucken des Vorrichtungscoupons (106) auf den Hohlraum (903), sodass eine Oberfläche des Vorrichtungscoupons (106) direkt an der Bondingoberfläche anliegt und mindestens ein Kanal zwischen dem Vorrichtungscoupon (106) und einer Seitenwand des Hohlraums (903) vorhanden ist; und
Füllen des mindestens einen Kanals mit einem Füllmaterial (907) über einen Spin-Coating-Prozess, um eine Brücke zu bilden, die die photonische Komponente (110) mit dem Wellenleiter (102) koppelt.

2. Das Verfahren nach Anspruch 1, ferner umfassend einen Schritt des Aushärtens des Füllmaterials, nachdem es spinbeschichtet wurde.

3. Das Verfahren nach Anspruch 1 oder 2, wobei der Vorrichtungscoupon (106) eine erste und zweite Elektrode (105a, 105b) umfasst.

4. Das Verfahren nach einem der vorhergehenden Ansprüche, wobei sich ein Siliziumwellenleiter (1408) in einer Vorrichtungsschicht (901) eines Siliziumauf-Isolator-Wafers befindet, der in der Plattform (101) bereitgestellt ist, wobei der Siliziumwellenleiter direkt an dem Hohlraum (903) anliegt.

5. Das Verfahren nach Anspruch 4, wobei der Siliziumwellenleiter einen Wellenleiter beinhaltet, der sich in der Höhe in einer Richtung zu dem Hohlraum (903) hin von einer ersten Höhe zu einer zweiten Höhe verjüngt, wobei die erste Höhe größer als die zweite Höhe ist.

6. Das Verfahren nach einem der vorhergehenden Ansprüche, wobei der Siliziumwellenleiter (102) ein Bragg-Gitter beinhaltet.

7. Das Verfahren nach einem der vorhergehenden Ansprüche, wobei die Plattform (101) einen Siliziumnitridwellenleiter (1402) hat; wobei optional der Siliziumnitridwellenleiter ein Bragg-Gitter beinhaltet.

8. Das Verfahren nach einem der vorhergehenden Ansprüche, wobei die photonische Komponente (110) hergestellt ist aus:
III-V Materialien;
II-VI Materialien; oder
Gruppe IV Materialien.

9. Das Verfahren nach einem der vorhergehenden Ansprüche, wobei die photonische Komponente (110) entweder umfasst: einen regulären Quantentopf; oder einen Dreiecksquantentopf.

10. Das Verfahren nach einem der vorhergehenden Ansprüche, wobei die photonische Komponente (110) entweder ist:
ein Fotodetektor; oder
ein Elektroabsorptionsmodulator, EAM, der den Quantum-Confined-Stark-Effekt, QCSE, verwendet.

11. Das Verfahren nach einem der vorhergehenden Ansprüche 1-7, wobei die photonische Komponente (110) ein Elektroabsorptionsmodulator, EAM, ist, der den Franz-Keldysh, FK, Effekt verwendet.

12. Das Verfahren nach einem der vorhergehenden Ansprüche, ferner beinhaltend einen Schritt, vor dem Füllen des Kanals, des Auskleidens einer oder mehrerer Seitenwände des Hohlraums mit einer antireflektierenden Auskleidung; und/oder
ferner beinhaltend einen Schritt, vor dem Transferdrucken des Vorrichtungscoupons, des Bereitstellens einer antireflektierenden Beschichtung um eine oder mehrere laterale Seiten des Vorrichtungscoupons.

13. Das Verfahren nach einem der vorhergehenden Ansprüche, wobei das Füllmaterial ein Polymer ist, zum Beispiel Benzocyclobuten, oder das Füllmaterial Sol-Gel ist.

14. Eine optoelektronische Vorrichtung (100), die Folgendes beinhaltet:
einen Wellenleiter (102), der in einer Vorrichtungsschicht eines Wafers bereitgestellt ist;
eine photonische Komponente (110) eines Vorrichtungscoupons (106),
die sich in einem Hohlraum (903) des Wafers befindet; und
eine Brücke, die den Wellenleiter (102) an einer Seitenwand des Hohlraums (903) mit der photonischen Komponente (110) optisch koppelt;
wobei die Brücke mindestens teilweise aus einem Füllmaterial (907) gebildet ist, das ein Polymer beinhaltet.

15. Die optoelektronische Vorrichtung nach Anspruch 14, wobei die Brücke auch eine oder mehrere antireflektierende Beschichtungen beinhaltete, wobei optional die Brücke ein Paar antireflektierender Beschichtungen beinhaltet, die sich an gegenüberliegenden Seiten des Polymers befinden; und
wobei ferner optional eine des Paars antireflektierender Beschichtungen aus einer Schicht aus Siliziumnitrid gebildet ist, die sich zwischen einem Paar Siliziumdioxidschichten befindet.

## Revendications

1. Un procédé de fabrication d'un dispositif optoélectronique (100), le dispositif fabriqué comprenant un composant photonique (110) couplé à un guide d'ondes (102), le procédé comprenant :
l'obtention d'un coupon de dispositif (106), le coupon de dispositif (106) incluant le composant photonique (110) ;
l'obtention d'une plateforme (101), la plateforme comprenant une cavité (903) à l'intérieur de laquelle se trouve une surface de liaison pour le coupon de dispositif (106) ;
l'impression par transfert du coupon de dispositif (106) sur la cavité (903), de sorte qu'une surface du coupon de dispositif (106) vienne directement appuyer contre la surface de liaison et qu'au moins un canal soit présent entre le coupon de dispositif (106) et une paroi latérale de la cavité (903) ; et
le remplissage de l'au moins un canal par un matériau de remplissage (907) via un processus d'enduction centrifuge, pour former un pont couplant le composant photonique (110) au guide d'ondes (102).

2. Le procédé de la revendication 1, comprenant en outre une étape de durcissement du matériau de remplissage après qu'il a été enduit par centrifugation.

3. Le procédé de la revendication 1 ou 2, dans lequel le coupon de dispositif (106) comprend une première et une seconde électrode (105a-105b).

4. Le procédé de l'u ne des revendications précédentes, dans lequel un guide d'ondes en silicium (1408) est dans une couche de dispositif (901) d'un wafer silicium-sur-isolant disposé dans la plateforme (101), le guide d'ondes en silicium venant directement appuyer contre la cavité (903).

5. Le procédé de la revendication 4, dans lequel le guide d'ondes en silicium comprend un guide d'ondes dont la hauteur se rétrécit dans une direction allant vers la cavité (903), d'une première hauteur à une seconde hauteur, la première hauteur étant supérieure à la seconde hauteur.

6. Le procédé de l'une des revendications précédentes, dans lequel le guide d'ondes en silicium (102) comprend un réseau de Bragg.

7. Le procédé de l'une des revendications précédentes, dans lequel la plateforme (101) possède un guide d'ondes en nitrure de silicium (1402) ; dans lequel le guide d'ondes en nitrure de silicium comprend éventuellement un réseau de Bragg.

8. Le procédé de l'une des revendications précédentes, dans lequel le composant photonique (110) est réalisé en :
matériaux III-V ;
matériaux II-VI ; ou
matériaux du groupe IV.

9. Le procédé de l'une des revendications précédentes, dans lequel le composant photonique (110) comprend :
soit un puits quantique régulier ;
soit un puits quantique triangulaire.

10. Le procédé de l'une des revendications précédentes, dans lequel le composant photonique (110) est :
soit un photodétecteur ;
soit un modulateur d'électro-absorption, EAM, utilisant l'effet Stark confiné quantiquement, QCSE.

11. Le procédé de l'une des revendications 1 à 7 précédentes, dans lequel le composant photonique (110) est un modulateur d'électro-absorption, EAM, utilisant l'effet Franz-Keldysh, FQ.

12. Le procédé de l'une des revendications précédentes, comprenant en outre, avant le remplissage du canal, une étape de revêtement d'une ou plusieurs parois latérales de la cavité par un revêtement anti-réfléchissant ; et/ou
comprenant en outre, avant l'impression par transfert du coupon de dispositif, une étape d'obtention d'un revêtement anti-réfléchissant autour d'un ou plusieurs côtés latéraux du coupon de dispositif.

13. Le procédé de l'une des revendications précédentes, dans lequel le matériau de remplissage est un polymère, par exemple du benzocyclobutène, ou le matériau de remplissage est un sol-gel.

14. Un dispositif optoélectronique (100) comprenant :
un guide d'ondes (102), obtenu dans une couche de dispositif d'un wafer ;
un composant photonique (110) d'un coupon de dispositif (106), situé à l'intérieur d'une cavité (903) du wafer ; et
un pont, qui couple optiquement le guide d'ondes (110) au composant photonique (110) au niveau d'une paroi latérale de la cavité (903) ;
dans lequel le pont est au moins partiellement formé d'un matériau de remplissage (907) qui comprend un polymère.

15. Le dispositif optoélectronique de la revendication 14, dans lequel le pont comprend également un ou plusieurs revêtements anti-réfléchissants ;
dans lequel le pont comprend éventuellement une paire de revêtements anti-réfléchissants, situés sur des côtés opposés du polymère ; et
dans lequel l'un de la paire de revêtements anti-réfléchissants est éventuellement formé d'une couche de nitrure de silicium située entre une paire de couches de dioxyde de silicium.
